# EUROPEAN PATENT SPECIFICATION

(11) **EP 1 887 609 B1**
(45) Date of publication and mention of the grant of the patent: **03.02.2010**
(21) Application number: 07112506.6
(22) Date of filing: 16.07.2007
(51) Int. Cl.: H01J 37/32

(54) **Equipment for the plasma treatment of one- or two-dimentional articles**
Vorrichtung zur Plasmaverarbeitung ein- oder zweidimensionaler Artikel
Appareil pour le traitement plasma d'articles mono ou bidimensionnels

(30) Priority: 17.07.2006 IT TO20060522
(43) Date of publication of application: 13.02.2008
(73) Proprietor: Apostolo, Giorgio, 10018 Pavone Canavese (Torino) (IT)
(72) Inventor: Apostolo, Giorgio, 10018 Pavone Canavese (Torino) (IT)
(74) Representative: Deambrogi, Edgardo

(56) References cited:
- EP-A- 0 805 476
- EP-A- 1 115 141
- US-A1- 2004 187 783

## Description

The present invention relates in a general way to the plasma treatment of one- or two-dimensional products, and more specifically to an equipment for the continuous plasma treatment at atmospheric pressure of an article in wire, strip, sheet or panel form.

The plasma is a gas composed of neutral particles, electrons and ions which interact continuously with each other. A plasma is generated by the ionization of neutral particles, for example by collision with fast electrons or ions or neutral atoms having sufficient energy, and this is generally carried out by means of ionization processes taking place in what are called support gases, in the presence of electrical discharges within an arrangement of opposing cathode and anode electrodes.

The industrial applications of plasma under vacuum include the manufacture of integrated circuits, the machining of tools and industrial metals, the forming of corrosion-proofing deposits and thermal barriers on consumer products.

The treatment of products with plasma in air, in other words in a free atmosphere and at atmospheric pressure, is currently used, for example, in the welding and cutting of materials and in the destruction of toxic and/or harmful wastes.

An important application of plasma technology, both under vacuum and at atmospheric pressure, is to the processing of textiles, for example for imparting hydrophilic properties to synthetic and natural textiles before dyeing and printing processes, or for imparting shrinkproofing and anti-felting properties to wool textiles, as well as for surface activation of textiles to improve the subsequent adhesion of chemical agents having properties of stainproofing, water-repellence, fireproofing, etc.

These applications are particularly advantageous when used to replace processes based on chemical treatments, since they are environmentally friendly, "dry" and economical processes.

Plasma technology is also used for depositing thin films on textiles, by injecting into the discharge area chemical precursors in the vapour phase which are dissociated from the plasma, thus creating elementary molecules which can be deposited and bound to the surface of the textile.

Equipment for continuous plasma treatment of textiles conventionally has a system for conveying the textile strip from external processing or storage stations to a plasma treatment region, including one or more cathode electrodes and one or more anode electrodes placed opposite each other, between which a high voltage of the order of magnitudes of kilovolts is established to form the electrical discharge which generates the plasma, and then from this region outward to subsequent processing or storage stations.

A plasma support gas is fed into the region lying between the cathode and anode electrodes, the gas mixture being specified according to the treatment for which the equipment is to be used.

The treated article is made to pass between the electrodes and is exposed to the plasma region to apply the desired treatment. Conventionally, the mechanical configuration for advancing the article being treated makes use of the anode electrode itself, which may be cylindrical or flat, as the support for the movement of the article.

US 2004/187783 A1 discloses an equipment for the plasma treatment of substrates, comprising a plurality of cathode electrodes and a roller-shaped anode electrode circumferentially facing the cathode electrodes, which form between them an electrical discharge region for the formation of a gas plasma. Gas supply units are located between a respective pair of cathode electrodes (or of separated portions of a single cathode electrode), and the anode electrode is arranged for transporting the substrate to be exposed to a gas activated by means of plasma discharge.

The quality of the article processed in this way depends to a considerable degree on the uniformity of the treatment to which it is subjected in the equipment, and this uniformity is determined by the correctness of the exposure of the article to the plasma region, in other words to the flow of gas/plasma.

The positioning of the gas diffuser elements and the plasma generation electrodes with respect to each other is therefore particularly relevant.

The object of the present invention is to provide an equipment for the plasma treatment of one- or two-dimensional articles, in wire, strip, sheet or panel form, and particularly in which the diffusion of the plasma onto the processed article is improved with respect to the prior art.

For this purpose, the invention proposes an equipment having the characteristics claimed in Claim 1.

Specific embodiments are described in the dependent claims.

Other features and advantages of the invention will be revealed more fully in the following detailed description which is given by way of non-limiting example with reference to the appended drawings, in which:
Figure 1 is an exemplary perspective view of an equipment according to the invention;
Figure 2 is a schematic sectional view of a cathode electrode of the equipment of Figure 1;
Figure 3 is a schematic exploded perspective view of an anode electrode of the equipment of Figure 1;
Figures 4 and 5 are sectional views of two variant embodiments of a gas diffuser element of the equipment of Figure 1;
Figures 6a and 6b are complete schematic representations, in exploded and assembled states, of a diffuser element according to the variant of Figure 4;
Figures 7a and 7b are complete schematic representations, in exploded and assembled states, of a diffuser element according to the variant of Figure 5; and
Figures 8a, 8b and 8c are schematic representations of the arrangement of the gas diffuser elements in a first, second and third embodiment, respectively, of the equipment proposed by the invention.

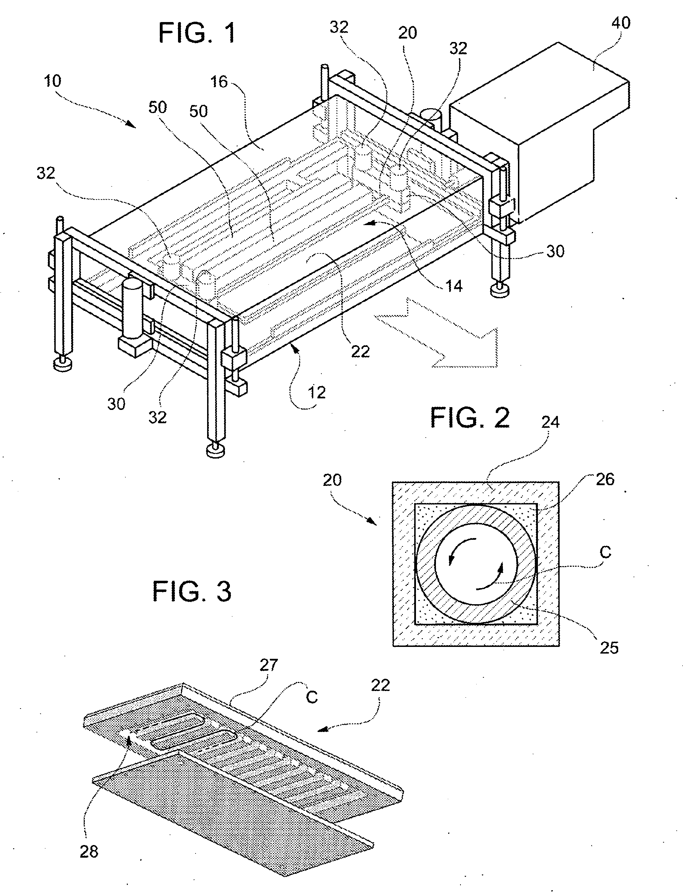

An equipment for plasma treatment is generally indicated with 10 in Figure 1. It comprises a frame 12 for supporting an arrangement of electrodes 14, surmounted by a protective cover 16, made for example from rigid and transparent plastics material to allow inspection of the equipment.

The electrode arrangement 14 comprises a plurality of cathode electrodes 20 (of which only the first, in the advanced position, is visible in Figure 1), facing at least one lower anode electrode 22, the electrodes forming between them an electrical discharge region D suitable for the formation of a gas plasma.

With reference to Figure 2, in the currently preferred embodiment the cathode electrodes 20 are made in the form of bars positioned parallel to each other, each bar comprising tubular elements of electrically conducting material enclosed in electrically insulating coverings.

Specifically, each cathode electrode 20 includes a ceramic tube 24 of substantially square cross section, made for example from 99.7% pure alumina, supported at both ends by supports 30 of electrically insulating material arranged to ensure that the electrodes are in alignment and kept parallel. The supports 30 are made, for example, from Teflon, which is a good electrical insulator and which can also withstand the high temperatures reached in the equipment. In turn, the Teflon supports 30 are supported by terminal insulating supports 32, of essentially cylindrical shape for example and also made from ceramic material, which can be connected to the protective upper cover of the equipment. If the equipment is large, each electrode bar is advantageously supported by auxiliary intermediate insulating supports, which may be of the suspended type or may be fixed at their tops to the protective cover 16 or to elements of the frame, spaced at regular intervals over the length of the bar.

Clearly, the supports can allow a different number of cathode electrodes to be housed, depending on the designed type of machine and the specific application which is desired.

A tube of electrically conducting material 25 such as copper, preferably of cylindrical shape, is inserted into the ceramic tube 24, the spaces 26 formed between the copper tube 25 and the inner wall of the ceramic tube 24 being filled with copper powder. Clearly, the ends of the ceramic tube forming the outer shell of the bar are suitably sealed to prevent the leakage of the copper powder.

Because the electrode is formed in a tubular shape, a coolant liquid (such as dielectric oil) and pre-cooled forced air C can flow through the inside of the copper tube, to cool the electrodes and prevent the overheating of the whole equipment.

If no electrode cooling system is provided, the electrodes can be made by using a bar of electrically conducting material instead of a tubular element.

The individual conducting elements of the cathode electrodes are connected in parallel to the secondary of a transformer, indicated as a whole by 40 in Figure 1, whose primary is supplied by a generator having an adjustable frequency, preferably in the range from 1 to 20 kHz and up to 40 kHz, and having a voltage of several hundred volts, preferably in the range from 200 to 300 volts, in such a way as to establish a voltage of several kilovolts in the secondary, this voltage being preferably adjustable between 3 and 15 kilovolts, with the same frequency as that of the primary. The secondary voltage supplies the electrical discharge between the cathode electrodes and the anode electrodes to generate the plasma. The applied power can vary from 100 W to several tens of kW, with a power density preferably in the range from 0.5 to 5 W/cm².

With reference to Figure 3, the anode electrode 22 includes, in a preferred embodiment, a single metal panel 27 of aluminium, whose length is conveniently less than that of the bars of the cathode electrodes. The upper surface of the panel preferably has rounded edges in order to prevent the accumulation of charges on the angles, which would adversely affect the quality of the plasma discharge. In alternative embodiments (not shown), a plurality of adjacent anode electrodes can be provided.

In the lower portion of the panel forming the anode electrode (or a component of the electrode) there is provided a cooling circuit 28 in which a coolant liquid C can be made to flow along a tortuous path to keep the temperature of the anode electrode constant and prevent the overheating of the whole equipment.

The anode electrode is preferably mounted on a movable drawer structure, which can be removed from the frame 12 so as to move the anode electrode away from the cathode electrodes and allow access to the machine for inspection and cleaning.

In the operating configuration, the electrode arrangement has distance between the cathode electrodes and the anode electrode which is adjustable and is preferably not more than 2-3 mm.

The support gas for forming the plasma is fed through diffuser elements 50 of essentially parallelepipedal shape, positioned in a number equal to the number of the cathode electrodes and upstream to these cathodes over their length in the direction of advance of the article to be treated.

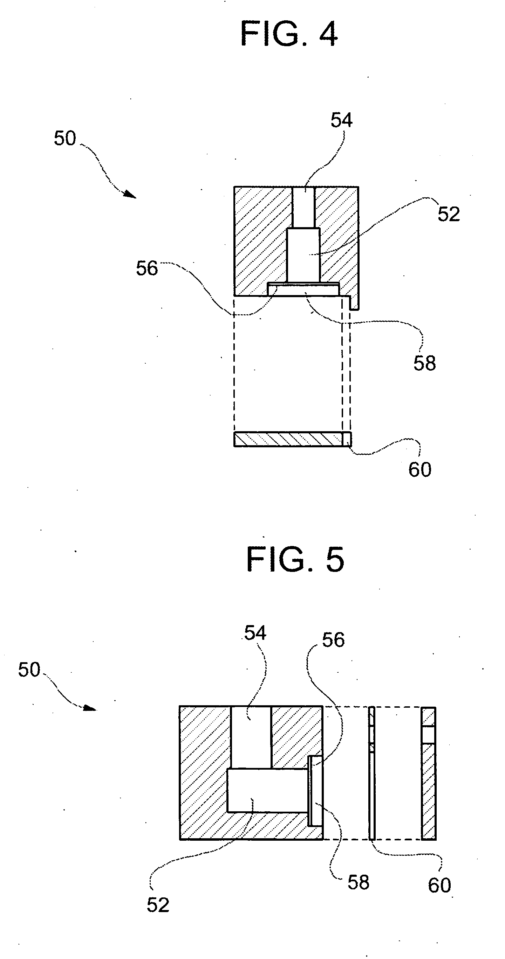

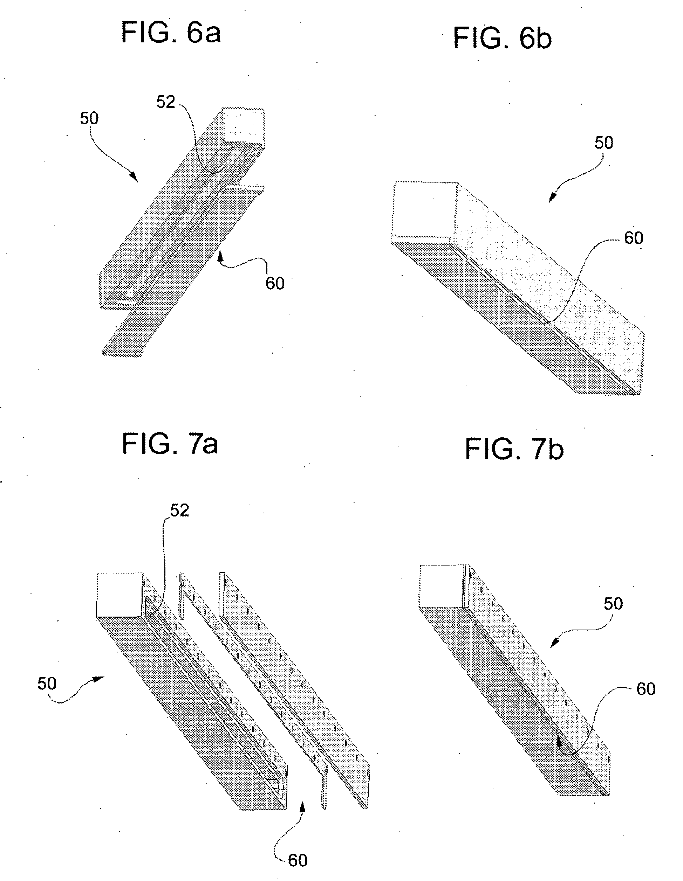

Two variant embodiments of a diffuser element are shown in section in Figures 4 and 5 respectively, and in a complete schematic representation in the exploded and assembled states respectively in Figures 6a and 6b (first variant) and in Figures 7a and 7b (second variant).

In both variants, each diffuser element 50 comprises a body, preferably made from aluminium, which has a main overpressure chamber 52 extending along the whole length of the diffuser, for receiving a gas injected into the diffuser through a plurality of upstream passages 54 formed in the body of the diffuser element at regular intervals over the length of the element and connected to external supply pipes.

This overpressure chamber 52 is closed downstream, on the side facing the plasma generation region lying between the anode and cathode electrodes, by a filter element 56, preferably a filter of porous material (such as paper or a polymer material) having a pore size of less than 5 microns, or of material in cloth form (such as steel cloth) with a mesh of less than 5 microns.

Downstream of the filter 56, a diffusion chamber 58 is formed in the body of the diffuser element, this chamber opening to the outside through a longitudinal gas diffusion slit 60, extending transversely with respect to the direction of movement of an article conveyed in the equipment and subjected to the plasma treatment (indicated by the arrow in Figure 1).

The longitudinal dimension of the slit 60 is at least equal to the transverse dimension of the discharge region formed within the cathode and anode electrode arrangement 14.

In the variant shown in Figures 4, 6a and 6b, the injection passages 54, the overpressure chamber 52, the filter 56 and the diffusion chamber 58 are aligned vertically in the orientation of the mounting of the diffuser.

In the variant shown in Figures 5, 7a and 7b, however, the path for the gas from the injection passages 54 to the slit 60 through the overpressure chamber 52, the filter 56 and the diffusion chamber 58 is L-shaped.

In both cases, the individual diffuser elements 50 are positioned upstream to the cathode electrodes 20 in the direction of advance of the article to be treated and are insulated from them by a wall of electrically insulating material (such as Pamitherm) and are mounted with the gas diffusion slit 60 facing the anode electrode. Specifically, the diffuser elements are positioned facing the corresponding (one or more) cathode electrodes in such a way that the gas diffusion slit is as close as possible to the electrode, in order to convey the gas as uniformly as possible into the plasma generation region.

The diffuser elements are also supported by ceramic end insulators and if necessary by auxiliary intermediate insulators, spaced at regular intervals along their length, and connected to the protective cover 16 of the equipment.

In operation, an article A to be treated is conveyed by the equipment by means of known conveyor rollers and is made to move inside the equipment within the electrode arrangement 14, at a predetermined speed of advance, for example about 50 m/min for textile strips and a few hundreds of metres per minute for wire articles.

The article is moved by a roller conveyor system external to the plasma processing equipment which causes it to advance at constant speed and aligns it on entry to and on departure from the equipment.

The plasma support gas is injected into the diffuser elements 50 through the upper passages 54. A slight overpressure is created inside the chamber 52 because of the presence of the filter element 56 downstream, enabling the gas to pass through the filter 56 in a uniform way over its whole length, passing into the diffusion chamber 58 and emerging from there through the slit 60 towards the discharge region D.

Since the diffusers 50 are mounted upstream of the cathode electrodes 20 with respect to the direction of movement of the article to be treated, the advancing motion of the article promotes the diffusion of the gas in the plasma generation region D, thus enabling the gas, which has already been distributed uniformly in the transverse direction with respect to the direction of advance, to be optimally distributed in the longitudinal direction also.

The gases typically used for textile processing applications are helium, oxygen, nitrogen and carbon dioxide. Helium makes the discharge more uniform, while the other gases impart specific properties. Oxygen, in particular, can be used to oxidize the surfaces to increase the affinity with water. Mixtures of helium and oxygen in a ratio of 1:3 - 1:5, for example, are used to provide hydrophilic properties in cotton textiles and shrinkproofing properties in wool.

The total flow of the gas mixture is variable according to the dimensions of the equipment (the number of cathode electrodes and the corresponding diffusers) and the speed of advance of the article to be treated, and is preferably in the range from 3 to 10 1/min, uniformly distributed over the plurality of electrodes provided.

It should be noted that the embodiment of the present invention proposed in the preceding discussion is purely exemplary and does not limit the present invention which is defined by the claims. A person skilled in the art can easily apply the present invention in different embodiments falling within the scope of the claims which do not depart from the principles described above, and which are therefore included in the present patent.

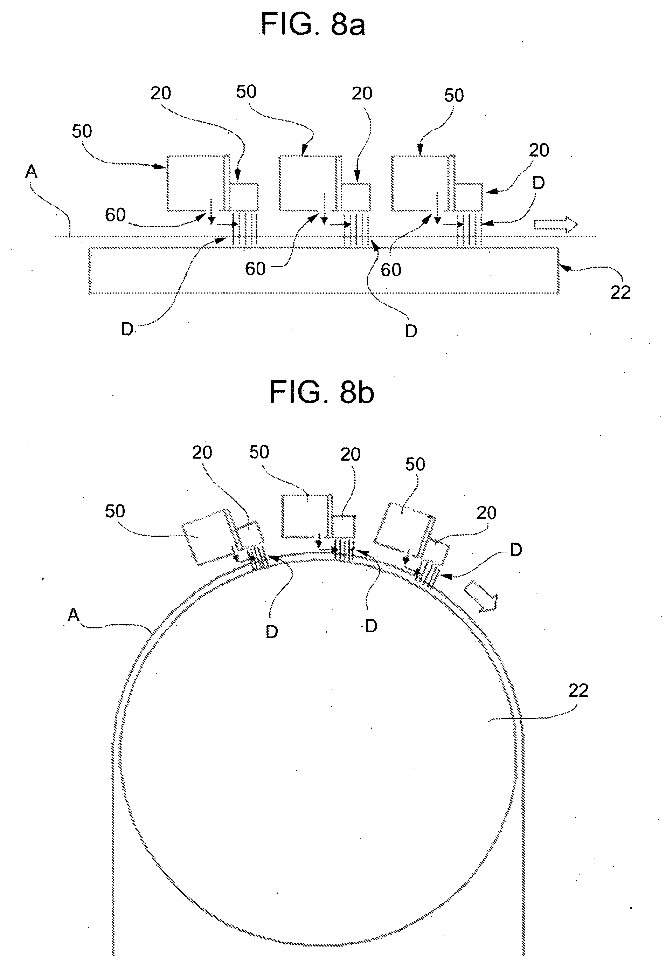

This is particularly applicable to the possibility of providing, as an alternative to the planar configuration shown in Figure 8a, a rotating cylindrical anode which can act as a support for moving the article, as shown in Figure 8b.

In this case also, gas diffuser elements 50 are positioned upstream to the bars of the cathode electrodes 20 in the direction of advance of the article to be treated and orientated in such a way that the plasma support gas emerges in a uniform way from the slit 60 in a direction perpendicular to the direction of movement of the article (indicated by the arrow). In this configuration it is possible to provide an anode cooling system using a flow of liquid coolant inside the cylindrical structure.

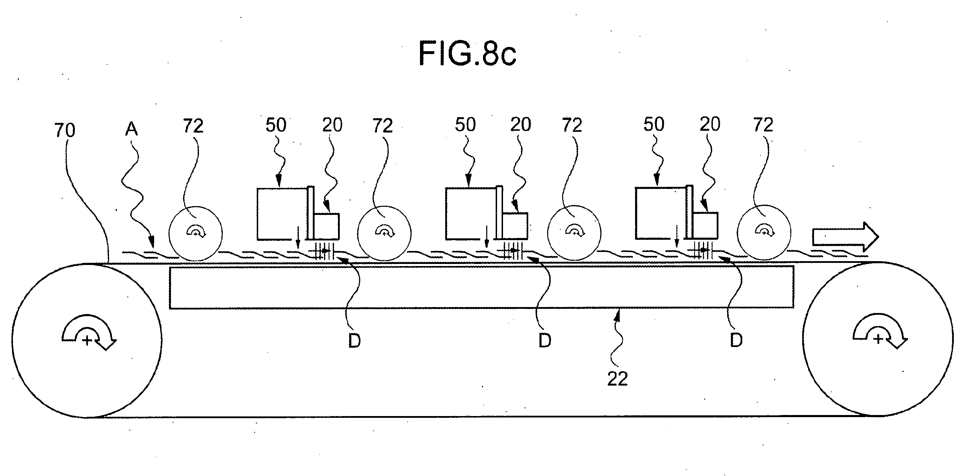

Another possible configuration is shown in Figure 8c, in which the equipment comprises a conveyor belt 70 for conveying loose material (fibres or the like) or, in general, discontinuous articles which could not otherwise be moved in the plasma formation region, unlike continuous textiles, films or wires. Drive rollers 72 can be provided at regular intervals to facilitate the transport of the material to be treated.

The conveyor belt is supported slidably by (or extended above) one or more metal anode panels, or can itself form the anode electrode, if it is made from metal, in which case the panels below have a supporting function.

In all cases, the conveyor belt can have microscopic perforations to permit the diffusion of the plasma support gas or gas mixture emitted by diffuser means positioned in the proximity of the anode electrode, below the conveyor belt, possibly enclosed inside the supporting panel or panels.

Clearly, provided that the principle of the invention is retained, the forms of application and the details of construction can be varied widely from what has been described and illustrated purely by way of example and without restrictive intent, without departure from the scope of protection of the present invention as defined by the attached claims.

## Claims

1. Equipment for the plasma treatment of one- or two-dimensional articles, comprising:
- an arrangement of electrodes (14) including a plurality of cathode electrodes (20) and at least one anode electrode (22) which face each other and which form between them an electrical discharge region (D) for the formation of a gas plasma;
- means (50) arranged to diffuse a plasma support gas or gas mixture in the aforesaid discharge region (D); and
- means arranged to convey an article (A) to be treated, adapted to continuously transport the said article (A) in the plasma formation region (D) at a predetermined speed in a direction of advance of the article (1) to be treated
**characterized in that** the said gas diffuser means comprise a plurality of diffuser devices (50), the number of which is equal to the number of cathode electrodes (20), each diffuser device (50) being positioned in the proximity of a respective cathode electrode (20), upstream of the latter in said direction of advance of the article (A) to be treated, and have a gas diffusion nozzle (60) facing the surface of the opposing anode electrode (22), which has a transverse extension with respect to the direction of advance of the article (A) which is at least equal to or greater than the transverse dimension of the discharge region (D), the advancing movement of the article to be treated promoting the uniform diffusion of the gas in the plasma formation region.

2. Equipment according to Claim 1, in which the said diffuser devices (50) are coupled to a corresponding cathode electrode (20) by the interposition of an insulating layer.

3. Equipment according to Claim 2, in which the said diffuser devices (50) include a substantially bar-like body which has inside it an overpressure chamber (52) which is adapted to be fed with a continuous flow of plasma precursor gas (or gas mixture) through a plurality of feed passages (54) and which is separated from a downstream gas diffusion chamber (58) by filter means (56), the said downstream diffusion chamber (58) having a longitudinal gas delivery slit (60).

4. Equipment according to Claim 3, in which the said filter means (56) comprise a filter of porous material with a pore size of less than 5 microns.

5. Equipment according to Claim 3, in which the said filter means (56) comprise a filter of material in the form of cloth with a mesh of less than 5 microns.

6. Equipment according to any one of the preceding claims, in which the said cathode electrodes (20) comprise electrode bars positioned transversely with respect to the direction of advance of the article (A) to be treated, each bar including a core (25) of electrically conducting material and an outer covering (24) of dielectric material.

7. Equipment according to Claim 6, in which the said core (25) of the cathode electrodes (20) is electrically connected to the secondary winding of a voltage transformer (40), whose primary winding can be connected to a controllable frequency voltage generator.

8. Equipment according to Claim 6 or 7, in which the said core (25) of the cathode electrodes (20) is a tubular core coupled to a cooling system which is adapted to make a coolant fluid (C) flow inside the said core (25).

9. Equipment according to any one of the preceding claims, in which the said anode electrode (22) comprises at least one flat metal panel (27) with rounded edges, the face of this panel opposite the discharge region (D) having channels (28) for the passage of a coolant fluid (C).

10. Equipment according to any one of Claims 1 to 8, in which the said anode electrode (22) comprises an electrically conducting cylindrical member rotated for the movement of the article (A) to be treated.

11. Equipment according to any one of Claims 1 to 8, in which the said anode electrode (22) comprises a conveyor belt (70) for conveying a discontinuous article (A) to be treated.

12. Equipment according to Claim 11, in which the said conveyor belt (70) is perforated for the diffusion of a plasma support gas or gas mixture emitted by diffuser means positioned in the proximity of the anode electrode (22).

## Patentansprüche

1. Ausrüstung für die Plasmabehandlung ein- oder zweidimensionaler Gegenstände, umfassend:
- eine Anordnung von Elektroden (14), die eine Mehrzahl von Kathodenelektroden (20) und mindestens eine Anodenelektrode (22) umfasst, welche einander zugewandt sind und zwischeneinander einen elektrischen Entladungsbereich (D) für die Bildung eines Gasplasmas bilden;
- Mittel (50), die dazu eingerichtet sind, ein Plasma-Trägergas oder eine Gasmischung in diesem Entladungsbereich (D) zu diffundieren; und
- Mittel, die dazu eingerichtet sind, einen zu behandelnden Gegenstand (A) zu befördern, und dazu angepasst sind, den Gegenstand (A) mit einer vorbestimmten Geschwindigkeit im Plasmabildungsbereich (D) in einer Vorschubrichtung des zu behandelnden Gegenstands (A) kontinuierlich zu transportieren,
**dadurch gekennzeichnet, dass** die Gasdiffusionsmittel eine Mehrzahl von Diffusionsvorrichtungen (50) umfassen, deren Anzahl der Zahl der Kathodenelektroden (20) entspricht, wobei jede Diffusionsvorrichtung (50) in der Nähe einer jeweiligen Kathodenelektrode (20) stromaufwärts von dieser in der Vorschubrichtung des zu behandelnden Gegenstands (A) positioniert ist, und eine Gasdiffusionsdüse (60) aufweisen, die der Oberfläche der gegenüberliegenden Anodenelektrode (22) zugewandt ist, welche eine Querausdehnung in Bezug auf die Vorschubrichtung des Gegenstands (A) aufweist, die zumindest gleich wie oder größer als die Querabmessung des Entladungsbereichs (D) ist, wobei die Vorschubbewegung des zu behandelnden Gegenstands die gleichmäßige Ausbreitung des Gases im Plasmabildungsbereich fördert.

2. Ausrüstung gemäß Anspruch 1, wobei die Diffusionsvorrichtungen (50) durch das Einfügen einer Isolierschicht mit einer entsprechenden Kathodenelektrode (20) gekoppelt sind.

3. Ausrüstung gemäß Anspruch 2, wobei die Diffusionsvorrichtungen (50) einen im Wesentlichen stabähnlichen Körper inkludieren, der in seinem Inneren eine Überdruckkammer (52) aufweist, die dazu angepasst ist, durch eine Mehrzahl von Zufuhrdurchgängen (54) mit einem kontinuierlichen Strom von Plasma-Vorläufergas (oder einer Gasmischung) gespeist zu werden, und die durch Filtermittel (56) von einer stromabwärts angeordneten Gasdiffusionskammer (58) getrennt ist, wobei die stromabwärts angeordnete Diffusionskammer (58) einen Gaszufuhr-Längsschlitz (60) aufweist.

4. Ausrüstung gemäß Anspruch 3, wobei die Filtermittel (56) einen Filter aus porösem Material mit einer Porengröße von weniger als 5 Mikrometern umfassen.

5. Ausrüstung gemäß Anspruch 3, wobei die Filtermittel (56) einen Filter aus einem Material in Form eines Stoffs mit einer Maschenweite von weniger als 5 Mikrometern umfassen.

6. Ausrüstung gemäß einem der vorhergehenden Ansprüche, wobei die Kathodenelektroden (20) Elektrodenstäbe umfassen, die in Bezug auf die Vorschubrichtung des zu behandelnden Gegenstands (A) quer positioniert sind, wobei jeder Stab einen Kern (25) aus einem elektrisch leitenden Material und eine Außenhülle (24) aus einem Dielektrikum umfasst.

7. Ausrüstung gemäß Anspruch 6, wobei der Kern (25) der Kathodenelektroden (20) mit der sekundären Wicklung eines Spannungswandlers (40) elektrisch verbunden ist, dessen primäre Wicklung an einem Spannungsgenerator mit regelbarer Frequenz angeschlossen sein kann.

8. Ausrüstung gemäß Anspruch 6 oder 7, wobei der Kern (25) der Kathodenelektroden (20) ein Hohlkern ist, der mit einem Kühlsystem gekoppelt ist, das dazu angepasst ist, eine Kühlflüssigkeit (C) im Inneren des Kerns (25) strömen zu lassen.

9. Ausrüstung gemäß einem der vorhergehenden Ansprüche, wobei die Anodenelektrode (22) mindestens eine flache Metallplatte (27) mit abgerundeten Kanten umfasst, wobei die Seite dieser Platte, die dem Entladungsbereich (D) gegenüberliegt, Kanäle (28) für den Durchgang einer Kühlflüssigkeit (C) aufweist.

10. Ausrüstung gemäß einem der Ansprüche 1 bis 8, wobei die Anodenelektrode (22) ein elektrisch leitendes zylindrisches Bauglied umfasst, das für die Bewegung des zu behandelnden Gegenstand (A) gedreht wird.

11. Ausrüstung gemäß einem der Ansprüche 1 bis 8, wobei die Anodenelektrode (22) ein Förderband (70) zum Befördern eines diskontinuierlichen, zu behandelnden Gegenstands (A) umfasst.

12. Ausrüstung gemäß Anspruch 11, wobei das Förderband (70) für die Diffusion eines Plasma-Trägergases oder einer Gasmischung, das bzw. die von in der Nähe der Anodenelektrode (22) positionierten Diffusionsmitteln verströmt wird, perforiert ist.

## Revendications

1. Equipement pour le traitement au plasma d'articles unidimensionnels ou bidimensionnels, comprenant :
- un agencement d'électrodes (14) comprenant une pluralité d'électrodes cathodiques (20) et au moins une électrode anodique (22) qui se font face et qui forment entre elles une région de décharge électrique (D) pour la formation d'un plasma gazeux ;
- des moyens (50) agencés pour diffuser un gaz ou un mélange gazeux de support de plasma dans la région de décharge (D) susmentionnée ; et
- des moyens agencés pour transporter un article (A) à traiter, adaptés pour transporter en continu ledit article (A) dans la région de formation de plasma (D) à une vitesse prédéterminée dans une direction d'avance de l'article (A) à traiter,
**caractérisé en ce que** lesdits moyens de diffusion de gaz comprennent une pluralité de dispositifs de diffusion (50), dont le nombre est égal au nombre d'électrodes cathodiques (20), chaque dispositif de diffusion (50) étant positionné à proximité d'une électrode cathodique (20) respective, en amont de cette dernière dans ladite direction d'avance de l'article (A) à traiter, et comportant une buse de diffusion de gaz (60) faisant face à la surface de l'électrode anodique (22) opposée, qui a une étendue transversale par rapport à la direction d'avance de l'article (A) qui est au moins égale ou supérieure à la dimension transversale de la région de décharge (D), le mouvement d'avance de l'article à traiter favorisant la diffusion uniforme du gaz dans la région de formation de plasma.

2. Equipement selon la revendication 1, dans lequel lesdits dispositifs de diffusion (50) sont couplés à une électrode cathodique (20) correspondante par l'interposition d'une couche isolante.

3. Equipement selon la revendication 2, dans lequel lesdits dispositifs de diffusion (50) comprennent un corps sensiblement en forme de barre qui comporte, à l'intérieur de celui-ci, une chambre de surpression (52) qui est adaptée pour recevoir un flux continu de gaz (ou de mélange gazeux) précurseur de plasma par l'intermédiaire d'une pluralité de passages d'alimentation (54) et qui est séparée d'une chambre de diffusion de gaz (58) en aval par des moyens formant filtre (56), ladite chambre de diffusion (58) en aval comportant une fente de distribution de gaz (60) longitudinale.

4. Equipement selon la revendication 3, dans lequel lesdits moyens formant filtre (56) comprennent un filtre en matériau poreux avec une taille de pore inférieure à 5 microns.

5. Equipement selon la revendication 3, dans lequel lesdits moyens formant filtre (56) comprennent un filtre en un matériau sous la forme d'un tissu avec des mailles de moins de 5 microns.

6. Equipement selon l'une quelconque des revendications précédentes, dans lequel lesdites électrodes cathodiques (20) comprennent des barres d'électrode positionnées transversalement par rapport à la direction d'avance de l'article (A) à traiter, chaque barre comprenant un noyau (25) de matériau électriquement conducteur et un revêtement externe (24) en matériau diélectrique.

7. Equipement selon la revendication 6, dans lequel ledit noyau (25) des électrodes cathodiques (20) est connecté électriquement à l'enroulement secondaire d'un transformateur de tension (40), dont l'enroulement primaire peut être connecté à un générateur de tension à fréquence contrôlable.

8. Equipement selon la revendication 6 ou 7, dans lequel ledit noyau (25) des électrodes cathodiques (20) est un noyau tubulaire couplé à un système de refroidissement qui est adapté pour faire circuler un fluide de refroidissement (C) à l'intérieur dudit noyau (25).

9. Equipement selon l'une quelconque des revendications précédentes, dans lequel ladite électrode anodique (22) comprend au moins un panneau métallique (27) plat avec des bords arrondis, la face de ce panneau qui est face à la région de décharge (D) comportant des canaux (28) pour le passage d'un fluide de refroidissement (C).

10. Equipement selon l'une quelconque des revendications 1 à 8, dans lequel ladite électrode anodique (22) comprend un élément cylindrique électriquement conducteur mis en rotation pour le mouvement de l'article (A) à traiter.

11. Equipement selon l'une quelconque des revendications 1 à 8, dans lequel ladite électrode anodique (22) comprend une courroie de transport (70) pour transporter un article (A) discontinu à traiter.

12. Equipement selon la revendication 11, dans lequel ladite courroie de transport (70) est perforée pour la diffusion d'un gaz ou d'un mélange gazeux de support de plasma émis par des moyens de diffusion positionnés à proximité de l'électrode anodique (22).
